# EUROPEAN PATENT APPLICATION

(11) **EP 4 625 466 A2**
(43) Date of publication of application: **01.10.2025**
(21) Application number: 25159333.1
(22) Date of filing: 21.02.2025
(51) Int. Cl.: H01J 37/20, H05B 3/14, H01J 37/26, H01J 37/28

(54) **HEATING ASSEMBLY FOR CHARGED PARTICLE BEAM SYSTEM**

(30) Priority: 04.03.2024 US 202418595124
(71) Applicant: FEI Company, Hillsboro, OR 97124-5793 (US)
(72) Inventor: MAHEL, Vojtech, 627 00 Brno (CZ); NOVÁK, Libor, 627 00 Brno (CZ); STRAKA, Branislav, 627 00 Brno (CZ); BUKVI OVÁ, Kristýna, 627 00 Brno (CZ)
(74) Representative: Boult Wade Tennant LLP

(57) **Abstract**

Systems, devices, and techniques for heating a sample are described. A heating assembly can include a membrane. The membrane can include carbon nanotube material. The heating assembly includes a support, mechanically coupled with the membrane. The support can be configured to integrate with a charged particle beam system. The heating assembly also includes a heating circuit, electrically coupled with the membrane. The heating circuit can be configured to direct an electrical current through the membrane.

## Description

### CROSS-REFERENCE TO RELATED APPLICATION

This application claims priority to US Non-Provisional Application S/N 18/595,124, filed March 4, 2024, the disclosure of which is incorporated herein by reference in its entirety.

### TECHNICAL FIELD

Embodiments of the present disclosure are directed to charged particle beam systems, as well as components, algorithms, and methods for their operation. In particular, some embodiments are directed toward techniques for heating of samples.

### BACKGROUND

In charged particle microscopy, characteristic x-rays are produced by excitation of inner-shell electrons as the beam interacts with atoms of a sample. X-ray signals are commonly used for elemental analysis in scanning electron microscope (SEM) systems. For example, x-ray signals can be used to generate energy dispersive x-ray (EDS) spectra, from which elemental composition of a sample can be measured.

X-ray measurements are sensitive to EM radiation (e.g., infrared-visible photons) that can create artefacts in EDS detector data. This presents challenges when thermal properties of materials are to be studied using EDS and other thermal-photon sensitive techniques. There is a need, therefore, for improved sample heating systems that can be used with EDS detectors.

### BRIEF SUMMARY

In a first aspect, a heating assembly includes a membrane. The membrane can include carbon nanotube material. The heating assembly includes a support, mechanically coupled with the membrane. The support can be configured to integrate with a charged particle beam system. The heating assembly also includes a heating circuit, electrically coupled with the membrane. The heating circuit can be configured to direct an electrical current through the membrane.

In some embodiments, the membrane defines a shape including a taper. The taper can be defined in a plane in cartesian coordinate space. The shape can include a double taper in the plane, such that a central region of the membrane is narrower than a peripheral region of the membrane. The heating assembly can be configured to operably couple with a sample stage of the charged particle beam system and for a sample to be disposed thereon. The support can include an electrically conductive portion, in electrical contact with the membrane and electrically coupled with the heating circuit. The heating circuit can be configured to direct the electrical current through the membrane via the electrically conductive portion. The support can be shaped to operably couple with an electron microscope sample holder. The heating circuit can include a probe. The probe can be configured to electrically couple with the membrane or the support. The probe can be a first probe, and the heating circuit can further include a second probe, reversibly coupled with the membrane, such that the electrical current is directed from the first probe to the second probe, via the membrane. The membrane can be at least partially freestanding across an aperture defined in the support. The carbon nanotube material can include a multiwall carbon nanotube felt. The membrane can include multiple layers of carbon nanotube material. In some embodiments, the heating circuit includes a probe. The probe can be electrically coupled with the membrane or a conductive portion of the support. The probe can be mechanically coupled with an actuator and can be moveable in one or more spatial dimensions. The probe can include a tip that is structured to interface with the membrane. The tip can include carbon nanotube material, can include filaments or other fibers resulting in a brush-like structure, and/or can be flexible.

In a second aspect, a charged particle beam system includes a charged particle beam source, a sample chamber, coupled with the charged particle beam source, and a heating assembly, disposed in the sample chamber. The heating assembly includes one or more features of the preceding aspect, alone or in combination. For example, the heating assembly can include a membrane, including carbon nanotube material, a support, mechanically coupled with the membrane, the support being reversibly coupled with a sample stage of the charged particle beam system and configured for a sample to be disposed thereon and irradiated by a charged particle beam generated by the charged particle beam source. The heating assembly can also include a heating circuit, electrically coupled with the membrane and the charged particle beam system and configured to direct an electrical current through the membrane. The heating circuit can be at least partially external to the sample chamber. For example, one or more components of the heating circuit can be external to the sample chamber, electrically coupled with one or more components internal to the sample chamber. In some embodiments, the system can further include an isolation chamber. The isolation chamber can include a fluid handling coupler and a deposition substrate. The deposition substrate can include a resistive heating circuit. The isolation chamber can define an aperture co-located with the deposition substrate. The isolation chamber can be disposed in the sample chamber. The aperture can be aligned with the charged particle beam source. The heating assembly can be disposed at least partially in the isolation chamber. The heating assembly can be disposed in the isolation chamber between the fluid handling coupler and the deposition substrate.

In a third aspect, a method for heating a sample includes directing an electrical current through a membrane of a heating assembly of one or more of the preceding aspects. Directing the electrical current through the membrane can include applying a power of about 30 W or less, about 20 W or less, about 10 W or less, about 5 W or less, about 4 W or less, about 3 W or less, about 2 W or less, about 1 W or less, about 0.5 W or less, about 0.4 W or less, about 0.3 W or less, about 0.2 W or less, and/or about 0.1 W or less through the membrane, including fractions, sub-ranges, or interpolations thereof.

In some embodiments, the membrane can have a sample disposed thereon. The method can further include removing material from the membrane in a region of the membrane peripheral to the sample and contacting the membrane with a probe, electrically coupled with the heating circuit. The probe can contact the membrane within the region peripheral to the sample. Removing the material can include irradiating the membrane using a beam of charged particles, using mechanical force, using directed EM radiation, and/or by igniting an arc or other discharge between the probe and the membrane.

The method can include heating the membrane to a temperature greater than a vaporization or sublimation temperature of a sample. The temperature can be determined based at least in part on the pressure in the isolation chamber and the composition of the sample. The method can include heating a deposition substrate. The deposition substrate can be heated to a substrate temperature below the vaporization or sublimation temperature of the sample. The method can include directing a beam of charged particles and/or a beam of photons toward the deposition substrate. The method can include exposing the deposition substrate to charged particles of the beam of charged particles and generating a deposited material on the deposition substrate. The beam of charged particles can be directed using a scan pattern. The deposited material can be disposed on the surface of the deposition substrate in accordance with the scan pattern. The method can also include introducing a carrier gas to the isolation chamber.

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims.

### BRIEF DESCRIPTION OF THE SEVERAL VIEWS OF THE DRAWINGS

The foregoing aspects and many of the attendant advantages of the present disclosure will become more readily appreciated as the same become better understood by reference to the following detailed description, when taken in conjunction with the accompanying drawings.
FIG. 1A is a schematic diagram illustrating an example charged particle beam system, in accordance with some embodiments of the present disclosure.
FIG. 1B is a schematic diagram illustrating the operation of the example charged particle beam system of FIG. 1A as a scanning electron microscope, including various detectors, in accordance with some embodiments of the present disclosure.
FIGs. 2A-2H are schematic diagrams illustrating example heating assemblies, in accordance with some embodiments of the present disclosure.
FIG. 3 is a schematic diagram illustrating an example charged particle beam system, in accordance with some embodiments of the present disclosure.
FIG. 4 is a schematic diagram illustrating an example heating assembly, in accordance with some embodiments of the present disclosure.
FIG. 5 is a schematic diagram illustrating an example charged particle beam system, in accordance with some embodiments of the present disclosure.
FIG. 6 is a schematic block flow diagram illustrating an example method for localized heating of a material sample, in accordance with some embodiments of the present disclosure.
FIGs. 7A-7C are schematic diagrams illustrating example configurations of one or more probes for heating of a material sample, in accordance with some embodiments of the present disclosure.
FIGs. 8A-8B are electron micrograph images demonstrating heating of an example material sample, in accordance with some embodiments of the present disclosure.
FIGs. 9A-9B are electron micrograph images demonstrating local heating of an example material sample, in accordance with some embodiments of the present disclosure.
FIGs. 10A-10B are electron micrograph images demonstrating local heating of an example material sample, in accordance with some embodiments of the present disclosure.
FIG. 11 is a schematic diagram illustrating an example system for charged particle beam induced deposition, in accordance with some embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been described, it will be appreciated that various changes can be made therein without departing from the spirit and scope of the disclosure. The forthcoming paragraphs describe embodiments of an analytical instrument system, components, and methods for heating a sample. Embodiments of the present disclosure focus on charged particle beam microscopy and microanalysis and related instruments in the interest of simplicity of description. To that end, embodiments are not limited to such instruments, but rather are contemplated for analytical instrument systems where analysis of materials and temperature-dependent behavior can be complicated by the relative dominance of characteristic thermal radiation originating from heat sources in a vicinity of a sample. In an illustrative example, x-ray microanalysis can include generating detector data using a sensor that is sensitive to infrared photons emitted by a heating stage that act as noise that impairs x-ray signal quality. Such techniques can benefit from improved heating assembly structure and construction to reduce the flux of infrared radiation reaching the detector. Further, while embodiments of the present disclosure focus on electron beam systems, additional and/or alternative instruments and modalities are contemplated, including but not limited to ion beam systems, photon beam (e.g., laser) systems, or the like.

Embodiments of the present disclosure include systems, methods, algorithms, and non-transitory media storing computer-readable instructions for heating a sample. In an illustrative example, a heating assembly can include a membrane, including carbon nanotube material, a support, mechanically coupled with the membrane, the support being configured to integrate with a charged particle beam system, a heating circuit, electrically coupled with the membrane and configured to direct an electrical current through the membrane. Advantageously, embodiments of the present disclosure reduce the thermal mass of the heating element, thereby reducing the flux of infrared radiation reaching the detector that is attributable to the heating assembly, while also preserving transparency to x-ray radiation, thereby filtering the radiation leaving the sample to further reduce infrared artefacts in x-ray detector data. Additional advantages of the present disclosure include, but are not limited to, improved dynamic response, improved localization of heating to individual samples, compatibility with multiple samples, compatibility with multiple different charged particle beam systems, improved manufacturability relative to alternative heating sources (e.g., MEMS-based heating assemblies), and suitability for use in beam-induced deposition techniques (e.g., electron beam induced deposition (EBID) and/or ion beam induced deposition (IBID)).

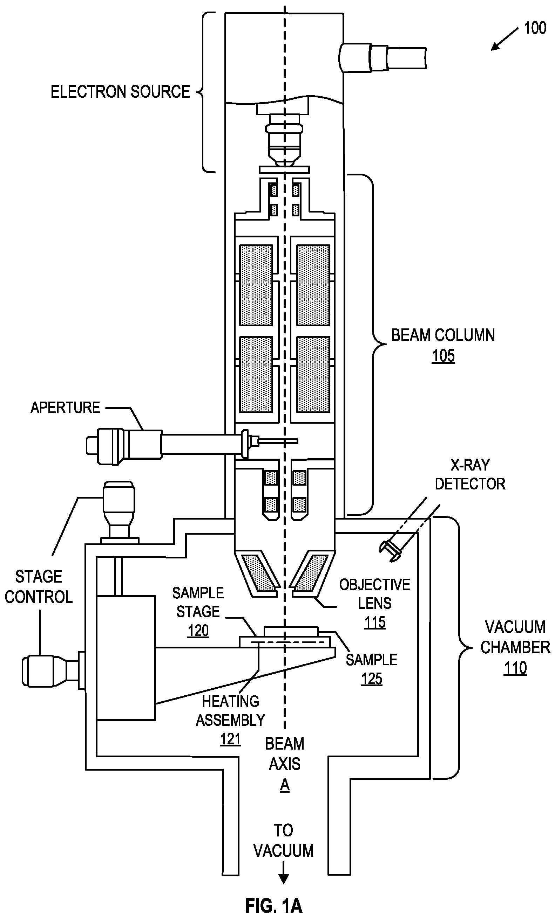

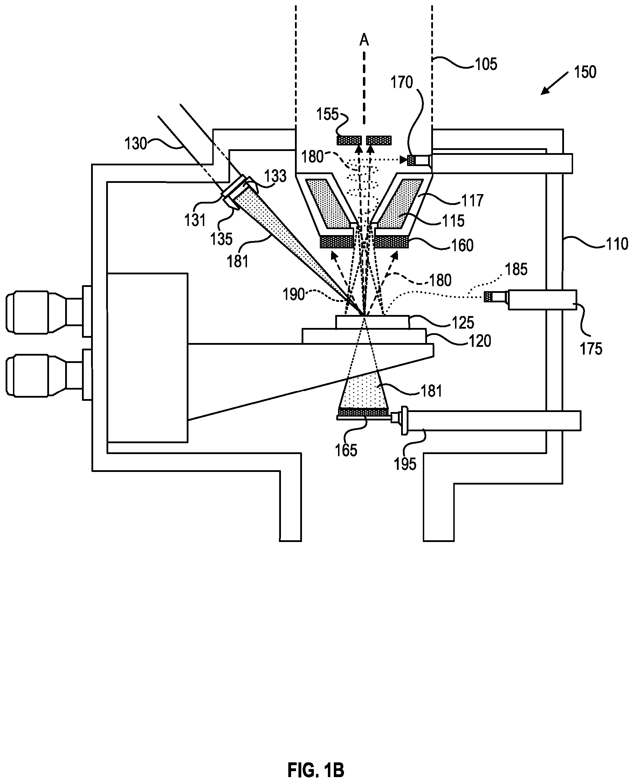

FIG. 1A is a schematic diagram illustrating an example charged particle beam system, in accordance with some embodiments of the present disclosure. Example charged particle microscope 100 includes multiple sections including an electron source, a beam column 105, and a vacuum chamber 110. The electron source includes high-voltage supply components, vacuum system components, and an electron emitter configured to generate a beam of electrons that is accelerated into the beam column 105. The beam column 105, in turn, includes electromagnetic lens elements that are configured to shape and form the beam of electrons from the electron source into a substantially circular beam with a substantially uniform profile transverse to a beam axis A, and conditions the beam to be focused onto a sample 125 by an objective lens 115, as described in more detail in reference to FIG. 1B.

The beam of electrons is typically characterized by a beam current and an accelerating voltage applied to generate the beam, among other criteria. The ranges of beam current and accelerating voltage can vary between instruments and are typically selected based on material properties of the sample or the type of analysis being conducted. Generally, however, in a scanning electron microscope, beams of electrons are characterized by an energy from about 0.1 keV (e.g., for an accelerating voltage of 0.1 kV) to about 50 keV and a beam current from picoamperes to microamperes.

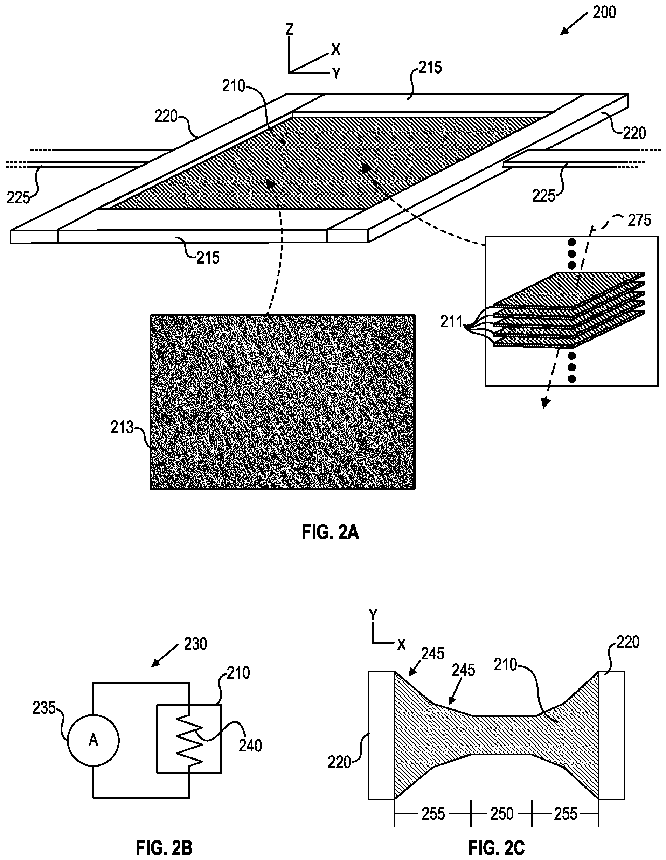

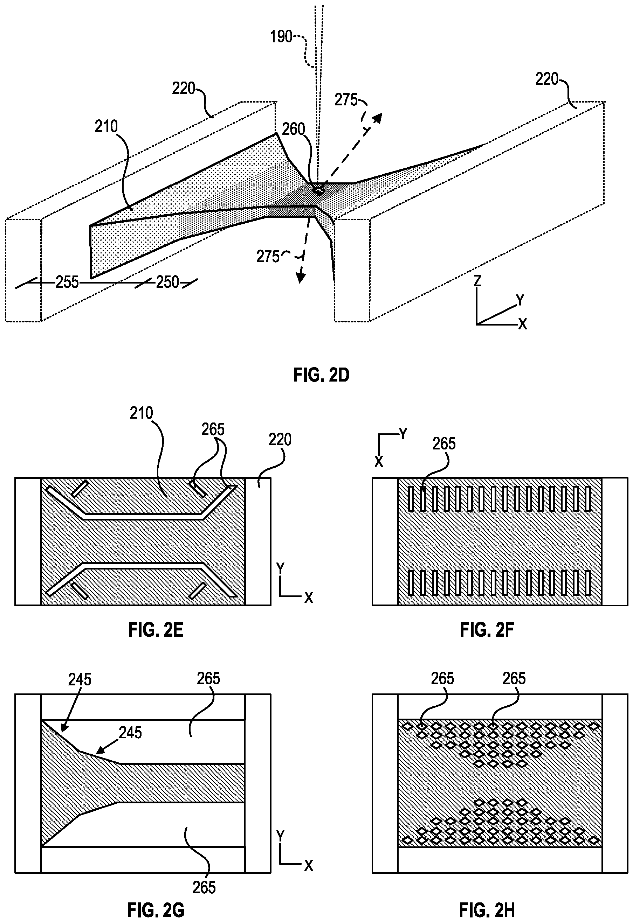

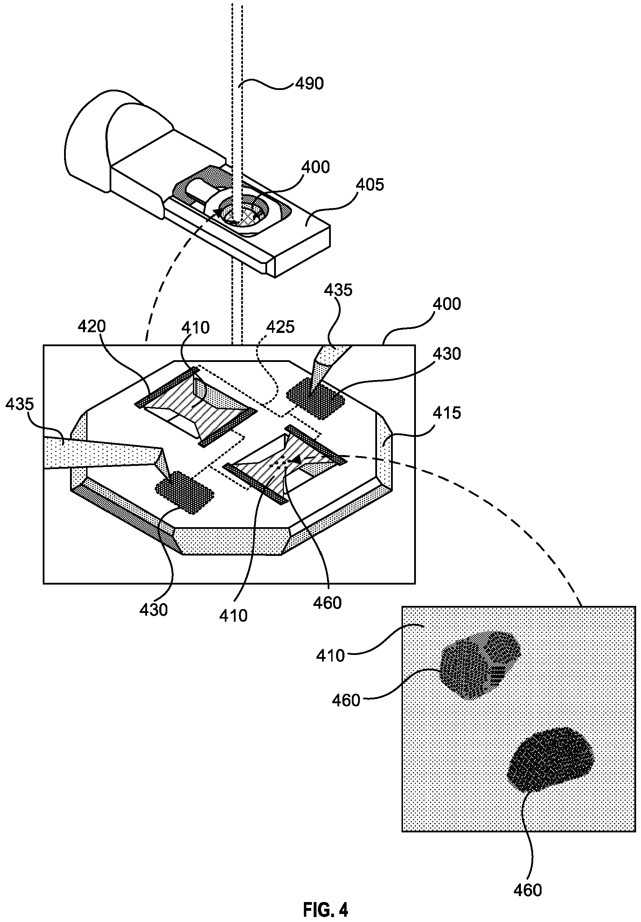

The vacuum chamber 110 and/or the beam column 105 can include multiple detectors for various signals, including but not limited to secondary electrons generated by interaction of the beam of electrons and the sample, x-ray photons (e.g., EDAX), other photons (e.g., visible and/or IR cameras), and/or molecular species (e.g., TOF-SIMS), as described in more detail in reference to FIG. 1B. The vacuum chamber 110 can also include a sample stage 120 that can be operably coupled with a multi-axis translation/rotation control system, such that the sample 125 can be repositioned relative to the beam axis A, as an approach to surveying and/or imaging the sample 125. As described in more detail in reference to FIG. 4A, the sample stage 120 can include, can be electrically coupled with, and/or can be mechanically coupled with a heating assembly 121. The heating assembly 121 can include constituent elements and/or materials permitting transmission of charged particles and/or other radiation (e.g., x-rays) through the sample and/or structures on which the sample is disposed (e.g., the membrane 210 of FIG. 2B). In this way, one or more charged particle and/or radiation sensors of the present disclosure can be disposed in the vacuum chamber 110 and/or in the beam column 105 and configured to detect characteristic signals emanating from the sample (e.g., reflected and/or transmitted), as described in more detail in reference to FIGs. 2A-2H. In this way, the heating assembly 121 can be configured to operably couple with the sample stage 120, including electrical (e.g., with a thermo-electrical control system) and mechanical couplings (e.g., for translating and/or tilting the heating assembly using stage controls).

Example charged particle microscope 100 is illustrated as a single-beam SEM instrument to focus description on applications of charged particle beam systems in heating applications. In some embodiments, charged particle microscope 100 can incorporate an ion-beam source (e.g., a focused ion beam, or FIB as part of a dual-beam system) adapted, for example, to modify a sample or for microanalysis. Similarly, the charged particle microscope 100 can include a source of photons, such as a laser or other electromagnetic radiation source. In this way, charged particle sensors of the present disclosure can be configured to generate detector data (e.g., images, line scans, x-ray spectra, etc.) in coordination with ion-sources used for modification and/or microanalysis of samples. In an illustrative example, a focused ion source (e.g., a p-FIB or the like) can be operably coupled with the vacuum chamber 110 and configured to incrementally remove portions of the sample 125 in a layer-wise manner. Between increments, x-ray microanalysis of the sample 125 affords a depth profile of elemental information in the sample 125, which can be useful for quality assurance in semiconductor applications, as well as in other fields.

FIG. 1B is a schematic diagram illustrating the operation of the example charged particle beam system of FIG. 1A as a scanning electron microscope, including various detectors, in accordance with some embodiments of the present disclosure. The detectors include a mirror detector (MD) 155, a pole-piece mounted detector (PMD) 160, an EDS-adapted STEM mode detector (SMD) 165, as well as other detectors, such as a through-the-lens detector (TLD) 170 and an Everhart-Thornley detector 175. Other detectors and sources that can be coupled with the vacuum chamber 110 include a conventional x-ray detector 130 (e.g., a silicon drift detector configured for energy dispersive x-ray spectroscopy). Embodiments of the present disclosure include charged particle microscopes including x-ray sources, x-ray detectors, ion-beam sources, mass spectrometers, optical sources (e.g., laser sources), or other sources as would be included in the complement of analytical instruments available for use in SEM microanalysis. At least some of the detectors of the example microscope 100 can be paired with filter(s) in proximity with or overlying the absorption surface(s) of the detector(s), as described in more detail in reference to FIGs. 2A-3C.

As illustrated, the mirror detector 155 and the TLD detector 170 are disposed in the beam column 105 or in the objective lens 115. For example, the mirror detector 155 can be disposed above the objective lens 115 and oriented with a sensor surface facing the sample stage 120. Advantageously, the position of the MD 155 in the beam column 105 makes the MD 155 well suited for substantially flat samples 125 or samples for which the sample stage 120 can be reoriented such that the normal angle is substantially aligned with the beam axis A, as angular distribution of BSE 180 emission is highest at the 45 degree angle to the surface of the sample 125 in such cases. MD 155 is illustrated without a retaining member or other support structure in FIG. 1B in the interest of focusing description on the position of MD 155 relative to BSEs 180, microscope 100 components, and the sample 125. In some embodiments, MD 155 is mounted on a retractable support 195, as illustrated in SMD 165. In this way, MD 155 can be introduced into position in the beam column 105 and/or objective lens 115 when a BSE 180 imaging/analysis mode is initiated by a user of charged particle microscope 100 and subsequently retracted from the position. In some embodiments, MD 155 is mechanically coupled with components of the beam column 105 and/or objective lens 115 and remains in position when not in use.

Pole-piece mounted detector 160 can be mechanically coupled with a pole piece 117 housing the objective lens 115 and oriented with the collector surface facing toward the sample stage 120. As with MD 155, PMD 160 can be mounted on a retractable support 195 instead of being mechanically coupled with the pole piece 117. Advantageously, mounting PMD 160 on the retractable support 195 permits the PMD 160 to be removed from between the sample stage 120 and the pole piece 117, allowing other probes, sources, or components to be introduced into the space (e.g., parabolic mirrors used for luminescence measurement and/or imaging).

An adapted STEM-mode detector 165, configured as an energy dispersive spectroscopy (EDS) detector can be mechanically coupled with a retractable support 195 configured to introduce the SMD 165 into a position such that the sample stage 120 is between the objective lens 115 / pole piece 117 and the SMD 165. SMD 165 can be oriented such that the detector surface faces an underside of the sample stage 120. In this way, x-rays 181 emanating from the sample 125 (e.g., from the region of the interaction volume of the sample in which x-rays are generated) can reach the detector surface and generate characteristic signals used for imaging and/or microanalysis. X-rays 181 can include x-rays generated from inner-shell excitations in atoms of the sample 125 that are directed through the sample rather than back toward the beam column 105. Forward Scattered Electrons (FSEs) emanating from the sample 125 can be absorbed by the heating assembly membrane, characterized by a relatively low electron-transmissivity, before reaching the detector surface to generate artefacts in the data (e.g., a background signal). In some embodiments, the membrane can be thin enough to permit some transmission of FSEs, thereby permitting STEM mode imaging and/or microanalysis of the sample. The thickness of the membrane can be determined based at least in part the transmissivity of the membrane material as a function of thickness for a given energy range of FSEs.

The x-ray detector 130 includes a detector 131 that is shielded from charged particles, photons, and other noise sources by a window 133 and a collimator 135, the collective result of which is a significant reduction of the solid collection angle. Additionally, to protect the window material and/or to reduce the interaction between magnetic components of the x-ray detector 130 and the beam of charged electrons, the x-ray detector 130 can be limited to a relatively low takeoff angle, for example, from about 30 to about 50 degrees as measured from a plane defined by the sample 125. The takeoff angle can be increased by tilting the sample 125, at a cost of reducing the functionality of detectors 155, 160, 165, and 170 during x-ray collection.

**FIG.2A** is a schematic diagram illustrating an example heating assembly 200, in accordance with some embodiments of the present disclosure. The heating assembly 200 includes a membrane 210 in a support 215. The support 215 includes one or more contact portions 220. The contact portions 220 can operatively couple (e.g., thermal coupling, mechanical coupling, etc.) the membrane 210 and/or the support 215 to one or more coupling members 225 by which the heating assembly 200 can be operatively coupled with the sample stage (e.g., sample stage 120 of FIGs. 1A-1B). The membrane 210 includes multiple layers 211 of filter material, as described in more detail in reference to FIG. 2B. The support 215 can be coupled with the membrane 210 over at least a portion of the periphery of the membrane 210. In this way, the support 215 mechanically supports the membrane 210, permitting the membrane 210 to be at least partially freestanding over a region of the heating assembly 200. In the illustrated example, the support 215 forms a frame over which the membrane 210 extends, such that the membrane 210 is freestanding over an aperture defined by the frame. Advantageously, disposing a sample on the region of the heating assembly 200, such that the sample is supported by the membrane 210, permits the sample to be heated by the membrane and irradiated by a beam of charged particles to generate detectable characteristic signals.

Embodiments of the present disclosure can be configured to be operably coupled with charged particle beam instruments. For example, the coupling member(s) 225 can include electrical couplers, mechanical couplers, optical couplers, or the like, to facilitate integrating the heating assembly 200 with a sample stage of a charged particle beam system. In the example of an SEM system, the coupling member(s) 225 can include two electrical contacts configured to electrically couple with elements of a heating circuit and one or more mechanical couplings (e.g., clips, tab-slot couplings, etc.) to mechanically retain the heating assembly in place while coupled with a sample stage. In this way, the heating assembly 200 can be moved using the stage controls of the SEM system and can direct an electrical current through the membrane 210.

The membrane 210 can include materials that exhibit selective transmissivity to x-rays 275. Selective transmissivity refers to the membrane 210 permitting at least a portion of incident x-rays 275 of a given energy to pass through the membrane 210, while absorbing relatively low-energy photons below a given threshold energy (e.g., uv-visible-IR photons) and absorbing or reflecting at least a portion of electrons incident on the membrane 210. For example, the membrane 210 can absorb, reflect, or otherwise block substantially all electrons having an energy of about 7.8 keV or less. In some embodiments, the threshold energy can be selected based at least in part on the thickness of the filter and/or the density of the filter as parameters. For example, a filter with a thickness of about 2 um can block incident electrons having an energy below about 2.5 keV. While lower than 7.8 keV, the thickness dependency of filter performance permits tuning of operating conditions. Further, the threshold energy can depend at least in part on the composition of the membrane 210. For example, a membrane 210 including multiwall carbon nanotubes can be characterized by a higher threshold energy, relative to a membrane 210 including single wall carbon nanotubes, based at least in part on the mass density of the membrane 211. Similarly, a membrane 210 having a relatively higher density of nanotubes per unit surface area can be characterized by a higher threshold energy than a membrane 210 having a relatively lower density of nanotubes per unit surface area.

In an illustrative embodiment, an areal density is defined as the mass of membrane 210 material per unit surface area (e.g., square centimeters). Characteristics of the membrane 210 can be described and/or related via the areal density, based at least in part on characteristic volumetric properties including volumetric density (e.g., mass per volume) of the carbon material and/or void percentage of the membrane (e.g., average proportion of empty space in the membrane). In some embodiments, the volumetric density of the carbon material is from about 0.11 g/cm³ to about 1.1 g/cm³, including sub-ranges fractions, and interpolations thereof. In some embodiments, transparency and thickness are inversely related. For example, for a given areal density, a membrane thickness of about 1.32 µm can correspond to a transmissivity at 550 nm of about 3.5 %, while a membrane thickness of about 2.64 µm can correspond to a transmissivity of about 0.12 %. In this way, for a given membrane, both the thickness and the transparency of the membrane can be referenced to the areal density. For example, the areal density can be from about 0.1 µg/cm² to about 330 mg/cm², including sub-ranges, fractions, and interpolations thereof, permitting the dimensions, number of layers, and individual layer thickness of the membrane 210 to be determined based at least in part on a balance between transparency and dimensional/space constraints.

In some embodiments, the membrane 210 includes a carbonaceous material 213. The carbonaceous material 213 can include carbon nanotube materials. The carbon nanotube materials can include single-walled nanotubes, double-walled nanotubes, multi-walled nanotubes, and/or mixtures thereof. The carbonaceous material 213 can include carbon nanofiber, nano-bamboo, other forms of sp² hybridized carbon, sp³ hybridized carbon, and/or mixtures thereof (e.g., a combination of graphitic and amorphous carbon). Nanotubes, nano-bamboo, and/or nanofibers can be oriented along a one or more in-plane directions and/or can be randomly oriented. For example, the membrane 210 can include layer(s) in which the carbon nanotubes making up a carbon nanotube felt are substantially aligned with an orientation direction. Different layers can be oriented in the same direction or in different direction(s). While substantially aligned with an orientation direction over a given layer and/or membrane 210, individual nanotubes, nanofibers, etc., can exhibit tortuosity (e.g., curving, angulation/kinking, looping, and/or spiral twisting segments) such that segment(s) of a given nanotube, nanofiber, etc., can be oriented away from the orientation direction. The membrane 210 can further include metal, ceramic, and/or nitride materials, for example, as a coating, inclusion, or other form that does not substantially limit the transmissivity and/or the thermal properties of the membrane 210.

The membrane 210 can have a thickness on the order of about 10 nm to about 10 um (e.g., from about 10 nm to about 99 um), including subranges (e.g., from about 0.5 um to about 30 um), fractions, and interpolations thereof. The membrane 210 can include multiple layers 211 of carbon nanotube material being from about 3 nm thick to about 1 um thick, individually, including subranges, fractions, and interpolations thereof. In an example, each layer can have a thickness of about 0.4 um, such that a membrane having two layers of carbon nanotube material can be about .8 um thick and a membrane having 25 layers of carbon nanotube material can be about 10 um thick. Without being bound to a particular physical phenomenon or mechanism, the filter 210 can have a thickness-dependent transmissivity, based at least in part on the absorbance of each constituent layer. In this way, the membrane 210 can include a number of layers that permits the filter 210 to absorb substantially all incident photons and/or charged particles, while permitting the transmission of a significant portion of x-rays 275.

Each layer can have a photon absorbance from about 1% to about 90% (e.g. as measured at 525 nm). In the example of 25 layers of carbon nanotube material, where each layer has an absorbance of about 40% at 525 nm, the overall absorption factor of the membrane 210 for photons at 525 nm can be about 1x10⁻⁹. In the example of a membrane 210 having a thickness of about 2 um, the transmissivity of Li Kα (55eV) x-rays 275 can be about 23%, corresponding to a significant improvement relative to current bulk heating stages that are opaque to x-rays. Further, comparative example detectors of the current art, for which carbon material is included as part of a window layer, typically include support grids that introduce artifacts and light-tight aluminum coatings on at least one surface of the window layer, which further reduces quantum efficiency of the detector. In contrast, membranes of the present disclosure can include an at least partially unsupported membrane 210, held by a frame (e.g., support 215 of FIG. 2A) around at least a portion of the membrane 210.

**FIG. 2B** illustrates that the membrane 210 can be electrically coupled to electronic components of a heating circuit 230, via the contact portion(s) 220. For example, the membrane 210 can form an electrical contact with the contact portion(s) 220. The electronic components can include one or more power sources 235. The heating circuit 230 can be at least partially external to the sample chamber (e.g., vacuum chamber 110 of FIGs. 1A-1B). For example, one or more components of the heating circuit can be external to the sample chamber, electrically coupled with one or more components internal to the sample chamber (e.g., by electrical feedthroughs).

In this way, an electrical potential (e.g., a voltage) can be applied across the membrane, by which an electrical current can be directed through the membrane and resistive heating can be induced. Advantageously, forming the membrane 210 with or from carbon nanotube material can improve the performance of the heating assembly 200 as a heating stage, while preserving the performance of the heating assembly for preserving and/or detecting characteristic signals from a sample disposed on the membrane 210.

In this context, the performance of the heating assembly 200 as a heating stage for sample microanalysis refers, at least in part, to one or more properties of the membrane 210 as a resistive heating element 240. For example, the resistive heating element 240 can be characterized by dynamic properties (e.g., rise time) and material properties (e.g., thermal mass). Carbon nanotube materials that are electrically conductive are characterized by improved thermal radiation properties relative to comparable resistive heating materials, such as carbon fiber materials, tungsten-based materials, or the like, that permits the example heating assembly 200 to generate relatively less thermal radiation (e.g., infrared-visible photons) than other materials at a comparable temperature and to reach a set point temperature in relatively shorter time. Advantageously, the relatively lower thermal radiation, permits heating assemblies of the present disclosure to be smaller than conventional bult heating stages, where the membrane 210 is at elevated temperatures, instead of a bult material. This, in turn, reduced the thermal mass that is heated, and permits a heating rate up to about 10000 Kelvin per second. This represents a significant improvement over the heating rate of conventional bulk heating stages.

**FIGs. 2C-2H** are schematic diagrams illustrating multiple example configurations of the membrane 210 of example heating assembly 200, in accordance with some embodiments of the present disclosure. The shape of the membrane 210 in one or more spatial dimensions can influence the behavior and performance of the membrane 210 as a heating element. Without being bound to a particular physical mechanism, the power dissipated in the membrane 210 can be a function of the current directed through the membrane 210 and the voltage drop across the membrane 210. Heat generation at a given position in the membrane 210 is a flux quantity, such that a local temperature of the membrane 210 can be related to the power dissipated in the membrane 210 and the geometric cross section of the membrane at a given position. In this way, temperature can be a local property for a given current, with narrower portions of the membrane 210 being hotter than wider portions of the membrane 210.

To that end, FIG. 2C illustrates an example membrane 210 defining a shape including a taper 245. The taper can be defined in a plane in cartesian coordinate space. In the example of FIG. 2C, the taper 245 is defined in an X-Y cartesian plane, such that the width of the membrane 210 in a "Y" dimension can be expressed as a function of position in an "X" dimension. The letters "X" and "Y" are used for convenience, and do not refer to true horizontal or vertical directions. The shape can include multiple taper angles, an example of which is shown in FIG. 2C, such that the shape includes a number of sides from 3 sides to 20 sides, or more. For example, a four-sided tapered membrane can define a trapezoidal shape, while FIG. 2C illustrates a double taper in the plane, such that a central region 250 of the membrane 210 is narrower than a peripheral region 255 of the membrane 210.

In some embodiments, the membrane 210 defines a shape including a taper defined in multiple planes. The shape can include a taper in an X-Y plane and an X-Z plane in cartesian space. In the example embodiment illustrated in FIG. 2D, the shape of the membrane 210 includes three-dimensional tapering from a first cross-sectional area in a Y-Z plane near the support portions 220 to a second, relatively smaller cross-sectional area in the Y-Z plane near a central region of the membrane 210. As with the tapered shape described in reference to FIG. 2C, the flux of electrons through the membrane can heat the central region 250 to a relatively higher temperature than the peripheral region 255. As described in more detail in reference to Examples 1-3, the membrane 210 can be repeatedly heated to a temperature at which a sample 260 disposed on the membrane 210 can undergo a phase transition. In this context, the term "phase transition" can refer to a change from a solid phase to a liquid phase (e.g., melting), but can also refer to other types of phase transition, such as crystal phase structures that are temperature and/or pressure dependent. In an illustrative example, a crystalline sample can be heated to elicit a transition from a first crystal phase to a second crystal phase and the transition between phases can be imaged using SEM (e.g. BSE channeling contrast) / using FIB or using electron microscopy analytical techniques (e.g., e-beam diffraction, x-ray spectroscopy, etc.). Advantageously, heating assemblies of the present disclosure permit one or more physical phases and/or phase transitions to be interrogated under charged particle irradiation. The membrane 210 exhibits improved heating properties and substantial transparency to characteristic signals generated by the interaction of the sample 260 and the beam of charged particles 190.

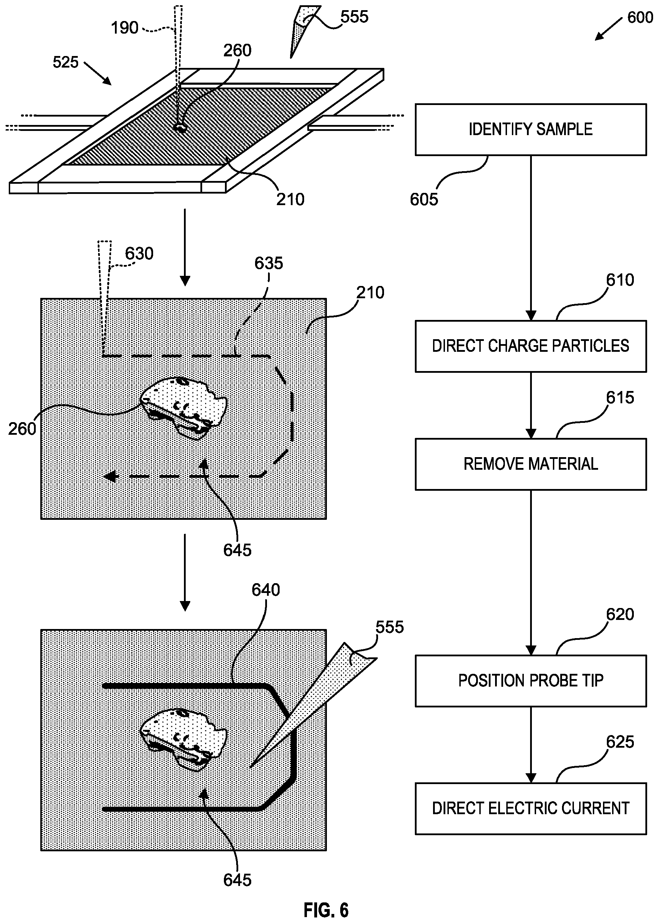

FIGs. 2E-2H illustrate alternative example embodiments that include apertures 265 formed in the membrane 210 by which the flow of current can be directed through the membrane 210 in a way that results in a relatively higher temperature in a localized region of the membrane 210. Advantageously, defining one or more apertures 265 in the membrane 210 can improve the structural stability of the membrane while imparting improved heating behavior (e.g., by reducing the effective cross section of the membrane 210). Further, defining the cross section as a function of position in the membrane 210 by patterning apertures 265 in the membrane 210 can improved manufacturability and/or can permit preparation of the membrane 210 in situ, in the presence of a sample 260. In an illustrative example, a beam of charged particles (e.g., ions, electrons, etc.) and/or photons (e.g., laser) can be directed toward the membrane 210 and used to pattern the aperture(s) 265, as described in more detail in reference to FIG. 6.

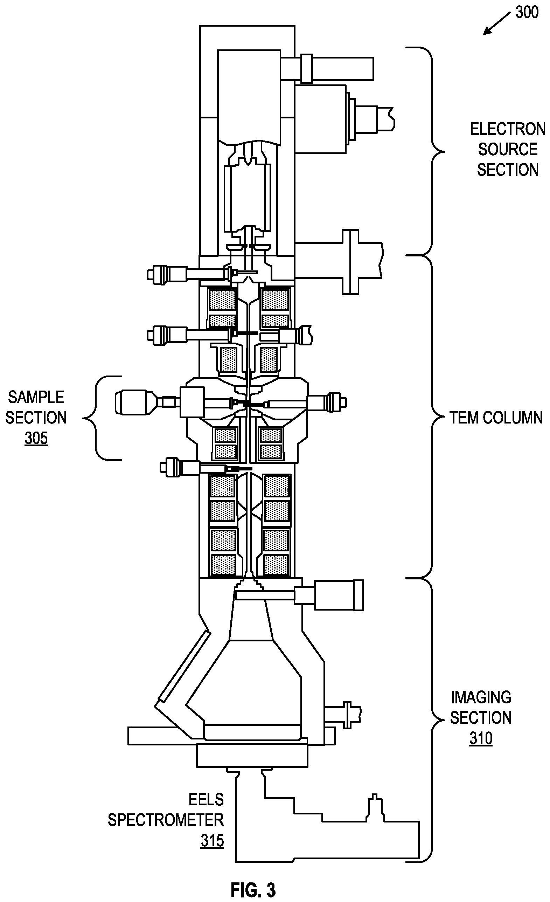

**FIG.** 3 is a schematic diagram illustrating an example charged particle beam system, in accordance with some embodiments of the present disclosure. In the following description, details of internal components and functions of the example TEM system 300 are omitted for simplicity and to focus description on embodiments of the present disclosure, as described in more detail in reference to FIG. 4. The example TEM system 300 includes an electron source section, a TEM column including a sample section 305, and an imaging section 310. The present disclosure focuses on techniques for improving the performance of heating assemblies for use in the sample section 305.

In brief, the electron source section includes electronics configured to energize a source of charged particles, which can include a high-voltage field-emission source or other sources of emitted electrons, such that a beam of electrons is formed and conducted through a vacuum into the TEM column. The TEM column includes components for beam forming, including electromagnetic lenses and/or electrostatic lenses, and multiple apertures to control properties of the beam of electrons. TEM column components include condenser lenses, objective lenses, projector lenses, aberration correctors, deflectors, stigmators, among others, as well as corresponding apertures. The sample section 305 hosts a sample 260 (in reference to FIG. 2A) disposed on a heating assembly through which the beam of electrons can be transmitted, as described in more detail in reference to FIG. 4. The sample section can include one or more types of detectors, such as x-ray detectors, secondary electron detectors, etc.

A state-of-the-art TEM column can have as many as four condenser lenses for flexible (e.g., step-wise or graduated) demagnification and concentration of the electron beam on the sample, and as many as five projector lenses for flexible magnification of the electron beam downstream of the sample to the detectors, and as many as two aberration correctors. Since a state-of-the-art aberration corrector can comprise additional lenses and several multipoles (e.g., four lenses and two-three or more multipoles), a modern TEM column can include up to about twenty lenses. Coordinated operation of the ensemble of lenses and other optical elements results in a given demagnification at the sample and magnification at the detector.

The detector section 310 includes one or more types of detector, sensor, screen, and/or optics configured to generate images, spectra, and other data for use in sample imaging and/or microanalysis. For example, the imaging section can include a scintillator screen, binoculars, transmission electron microscopy (TEM) detector(s) (e.g., pixelated electron detector, secondary electron detector, camera(s)), segmented STEM detector(s), and electron energy loss spectroscopy (EELS) spectrometer(s) 315, among others. The EELS spectrometer 315 functions as an energy filter at least in part by focusing the beam of electrons onto an electrostatic or magnetic dispersive element (also referred to as a "prism") that applies a force on an electron that is proportional to the velocity of the electron. In this way, electrons that have transferred energy to the sample (e.g., by inelastic collision(s)) can be redirected through the magnetic dispersive element and toward a detector. The detector can include a pixelated detector (e.g., a CCD device configured to detect electrons) that generates one or two dimensional EELS data, from which EELS spectra can be derived. In some embodiments, EELS spectrometer(s) 315 also include one or more optical elements, such as electromagnetic or electrostatic lenses and/or multipoles and/or accelerators, to condition and/or focus the scattered electrons onto the detector.

**FIG. 4** is a schematic diagram illustrating an example heating assembly 400, in accordance with some embodiments of the present disclosure. The example heating assembly represents an embodiment of the example heating assembly 200 described in reference to FIGs. 2A-2H, where the heating assembly 400 is shaped to operably couple with a TEM sample holder 405. To that end, the example heating assembly 400 includes one or more membranes 410 and one or more frames 415 including one or more conductive portions 420. The conductive portion(s) 420 can be electrically coupled with components of a heating circuit (e.g., as described in reference to FIG. 2B) configured to interface the frame 415 with the sample holder 405 and/or other components of a TEM system (e.g., example system 300 of FIG. 3). In an illustrative example, the electrical coupling of the frame 415 with the heating circuit can be facilitated by forming one or more conductive contacts 430 on the frame 415 and using one or more conductive probes 435.

The frame 415 can be or include a TEM grid or components of a TEM grid, such that a conventional TEM grid holder can be adapted for use with the heating assembly 400. Where conventional heating holders include electrical contacts, traces, etc. Such that the sample placement position is relatively limited to a heating position, membrane(s) 410 of the present disclosure can permit relatively unrestricted sample placement, facilitated by probe positioning when the probes are electrically coupled with the membrane 410, as described in more detail in reference to FIGs. 6-7C. In this way, the heating assemblies of the present disclosure permit samples 460 to be heated individually.

Advantageously, integration of the heating assemblies of the present disclosure in a TEM/STEM instrument can enable the generation of detector data at a level of spatial resolution exceeding what is available in SEM instruments. Further, TEM/STEM analysis enables crystal structure analysis of nanostructured samples 460, and enables probing temperature-dependent properties of samples 460 on a nanoscale. To that end, embodiments of the present disclosure include membrane(s) 410 that are substantially transparent to electrons (e.g., above a given threshold energy) and substantially transparent to x-rays (e.g., outside one or more characteristic energies associated with the membrane material).

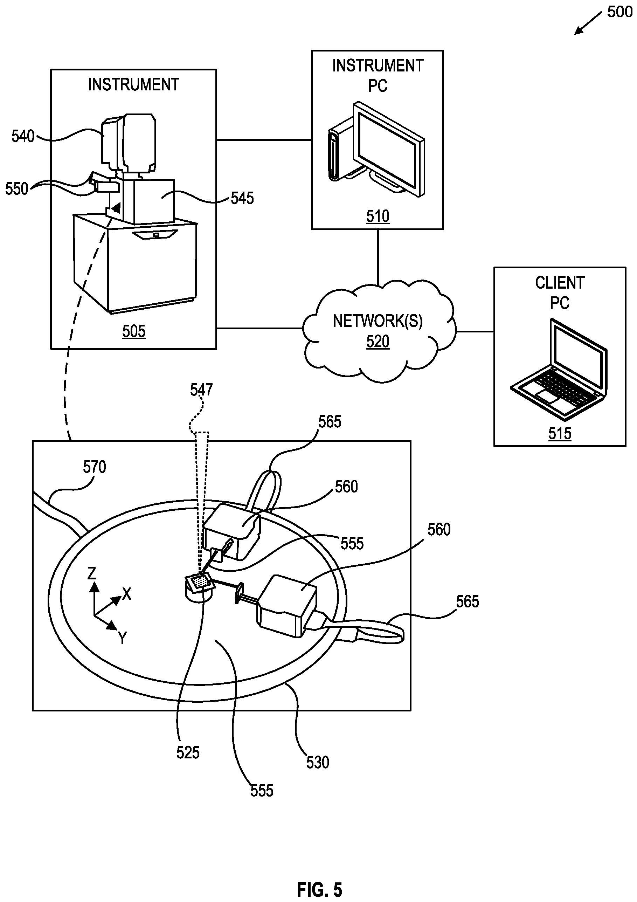

**FIG. 5** is a schematic diagram illustrating an example charged particle beam system, in accordance with some embodiments of the present disclosure. The example system 500 includes an instrument 505 (e.g., example system 100 of FIGs. 1A-1B), an instrument computing device (IPC) 510, and a client computing device 515, operably intercoupled via one or more networks 520. The example system 500 includes a probe assembly 530, electronically coupled with components of a heating assembly 525 via a heating circuit (e.g., as described in reference to FIGs. 2A-2H). The instrument 505 includes a test section 545 in which the probe assembly 530 is disposed, including vacuum components to isolate the heating assembly 525 from atmosphere. Coupled with the test section are a charged particle column 540 and one or more detectors 550. The charged particle column 540 can be an ion beam (e.g., focused ion beam (FIB)) column or an electron beam column. In some embodiments, the instrument 505 includes a FIB column and an electron beam column with one of the charged particle sources being coupled with the vacuum chamber at an angle relative to the charged particle column.

An electron beam column can generate a beam of electrons 547 and focus the beam of electrons 547 onto the heating assembly 525. The interaction of the beam of electrons 547 with the heating assembly 525 gives rise to one or more detectable signals, which can be received by the one or more detectors 550 operably coupled with the vacuum chamber 545 and configured to generate detector data based at least in part on measurement of the signal(s). In an illustrative example, the detector(s) 550 can include secondary electron detectors, backscattered electron detectors, photon detectors, imaging sensors (e.g., CCDs), x-ray detectors, or the like.

In contrast to a typical scanning electron microscope (SEM), the vacuum chamber 545 can omit sample manipulation tools, such as an interlock, sample stage, and the like, at least in part because the heating assembly 525 can be removably coupled with the probe assembly 530, which can be disposed on a stage, a cradle, or other retention assembly that provides electronic and thermal coupling with the test section. The beam of electrons 547 can be directed toward the heating assembly 525 using various operational modes, including but not limited to imaging mode, line scan mode, and spot mode. The probe assembly 530 can include individually addressable probes 555, movable in three spatial dimensions (labeled with "x-y-z" cartesian axes) by electromechanical actuators 560. In this way, probe tips can be displaced toward a position on the surface of the heating assembly 525 with nanometer-scale precision. In some embodiments, the probe assembly 530 is electronically coupled with components of the test section 535 via couplings 565 and 570, by which the actuators 560 can be driven (e.g., using drive signals) and the output signals can be generated.

The computing devices 510 and 515 can be general-purpose machines (e.g., laptops, tablets, smartphones, servers, or the like) that are configured to operate or otherwise interact with the instrument 505. The instrument 505, in turn, can include electronic components that form part of a special-purpose computing device, including control circuitry configured to drive the test loop, actuate the probe assembly 530, control the electron beam column 540, and operate the vacuum systems and thermal management systems. The IPC 510 can be a machine provided with software configured to interface with the instrument 505 and to permit a user of the instrument 505 to conduct a test of the heating assembly 525. Similarly, the client PC 515 can be configured to control one or more systems of the instrument 505 (e.g., via the IPC 510 and/or by interfacing with the instrument 505 over the network(s) 520) to conduct a test of the heating assembly 525. In some embodiments, the instrument 505, the IPC 510, and/or the client PC 515 are in separate physical locations and are coupled via the network(s) 520 and/or by other means, such as direct connection or by wireless connection (e.g., near-field radio). The network(s) 520 can include public networks (e.g., the internet) and/or private networks (e.g., intranet or local area networks). In some embodiments, the IPC 510 and/or the client PC 515 is/are configured to operate the instrument autonomously (e.g., without human intervention) or semi-autonomously (e.g., with limited human intervention, such as initiating a test, identifying a sample, and/or confirming an automated analytical result).

**FIG. 6** is a schematic block flow diagram illustrating an example process for localized or partially-localized heating of a material sample, in accordance with some embodiments of the present disclosure. One or more operations of the example process 600 can be executed by a computer system in communication with additional systems including, but not limited to, instrument systems, network infrastructure, databases, and user interface devices. In some embodiments, at least a subset of the operations described in reference to FIG. 6 are performed automatically (e.g., without human involvement) or pseudo-automatically (e.g., with human initiation or limited human intervention). In an illustrative example, operations for positioning a probe tip, displacing the probe tip, generating and/or directing a beam of charged particles, isolating a sample, and directing an electric current through a heating assembly can be executed automatically or pseudo-automatically. While example process 600 is described as a sequence of operations, it is understood that at least some of the operations can be omitted, repeated, and/or reordered. In some embodiments, additional operations precede and/or follow the operations of example process 600 that are omitted for clarity of explanation, for example, operations for calibration of the electron source, alignment and aberration correction of the beam of electrons, initializing probe position or the like. In this context, "localized" and "partially-localized" refers to using one or more movable electrical contacts (e.g., probe(s) 555 of FIG. 5) to direct electric current into the membrane (e.g., membrane 210 of FIG. 2A) in proximity to a sample. In this way, the current can be directed from the movable electrical contacts to a conductive portion of the heating assembly (e.g., the conductive portion(s) 220 of FIG. 2A) and/or from one movable contact to another movable contact, via the membrane.

At operation 605, the example process 600 includes identifying a sample. Identifying the sample can include one or more sub-operations directed at locating a sample (e.g., sample 260 of FIGs. 2A-2H) disposed on a membrane (e.g., membrane 210). Identifying the sample can include image processing sub-operations that can include human intervention, automated edge-finding and/or feature-tracking algorithms, by which the sample can be localized on the membrane. In this context, images can include various detector data generated by a charged particle beam system (e.g., secondary electron image data, backscattered electron image data, light camera image data, etc.).

At operation 610, the example process 600 includes directing charged particles toward the membrane 210. The charged particles in the context of operation 610 can include electrons and/or ions. In some embodiments, the current of charged particles can degrade or otherwise remove material of the membrane 210 in a prescribed location on the membrane 210. To that end, the current of charged particles can be directed toward the membrane using a beam of charged particles (e.g., generated using a SEM or other charged particle beam system) and/or by biasing a probe 555 relative to the membrane (or vice versa) and inducing a current between the probe 555 and the membrane 210.

At operation 615, the example process 600 includes removing material from the membrane 210 to at least partially isolate the sample 260 on a portion of the membrane 210, based at least in part on forming one or more apertures 640 (e.g., an example of the apertures 265 of FIGs. 2E-2H) in the membrane 210. Isolating the sample 260 can include patterning the membrane by translating the probe 555 or modifying scan control signals (e.g., associated with a scan circuit of example system 100 of FIG. 1, example system 500 of FIG. 5, etc.) such that charged particles are incident on the membrane 210 at multiple positions along a path 635. For example, the probe 555 can be biased relative to the membrane, such that an electric current can be used to locally ablate the membrane and form the aperture 640 (e.g., by igniting an arc, pulsed arc, etc.).

To that end, operations 610 and 615 of example process 600 can be parallelized and/or serialized in multiple iterations. For example, a beam of charged particles (e.g., beam 547 of FIG. 5) can be steered across the surface of the membrane 210 along the path 635 such that a current of primary electrons can be used to form the aperture 640. In this way, a region 645 of the membrane 210 peripheral to the sample 260 can be at least partially isolated and used for localized electrical heating of the membrane 210 and the sample 260. In some embodiments, operation 615 can also include using the probe 555 to mechanically engrave the aperture 640 and/or using an EM radiation source (e.g., a laser, pulsed laser, etc.) to ablate the membrane material.

At operation 620, the example process 600 includes positioning a probe 555 to form an electrical contact with the membrane 210 within the peripheral region 645 defined by the aperture(s) 640. While the probe 555 is illustrated as a defining conical shape, embodiments of the present disclosure include probes 555 of additional or alternative geometries. For example, a probe tip can define a shape that is irregular, branched, brush-like, or otherwise structured to reduce the likelihood that the probe 555 will pierce the membrane 210, rather than forming a durable electrical contact. In some embodiments, the probe 555 includes surface roughness and relatively high pliability, as an approach to improving the quality of contact with the membrane 210.

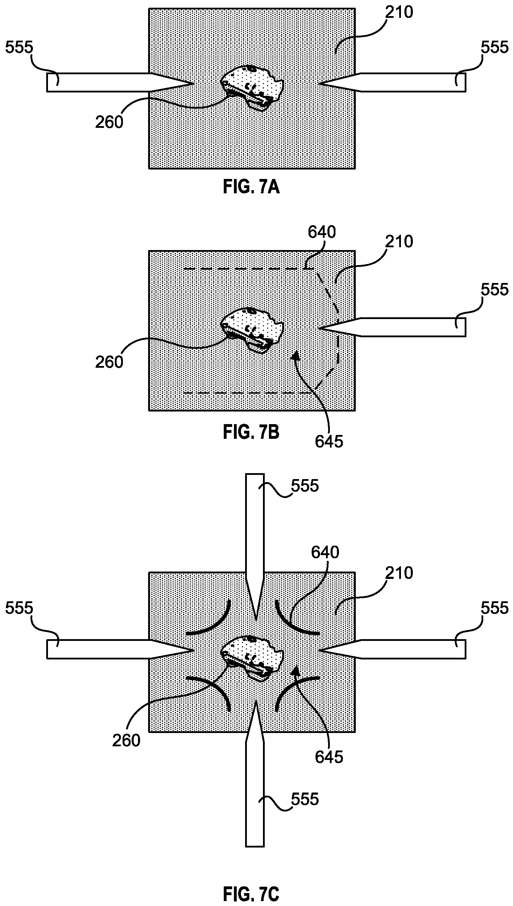

At operation 625, example process 600 includes directing an electric current through the membrane 210, using the probe 555 to localize the current through the peripheral region 645. In this way, the region 645 heats to a relatively high temperature, compared to the membrane material external to the region 645. Where a single probe 555 is used to direct current through the membrane 210, the current can be directed between the probe 555 and one or more of the conductive portions (e.g., portions 220 of FIG. 2A) of a support element of the heating assembly (e.g., example heating assembly 200 of FIG. 2A, example heating assembly 400 of FIG. 4, example heating assembly 525 of FIG. 5, etc). As described in more detail in reference to FIGs. 7A-7C, the number and relative position of the probe tip(s) 555 and aperture(s) 640 can differ.

Advantageously, example process 600 permits localized heating of an individual sample 260 on the membrane 210 that can otherwise support one or more other samples, as illustrated in FIG. 4. To that end, a single sample preparation and loading procedure can be used to prepare a multi-replicate microanalysis experiment, thereby improving throughput and efficiency in terms of time and complexity of preliminary operations.

FIGs. 7A-7C are schematic diagrams illustrating example configurations of one or more probes for heating of a material sample, in accordance with some embodiments of the present disclosure. Example embodiments of multi-probe configurations and membranes including multiple apertures 640 are illustrated. In FIG. 7A, two probes (e.g., probe 555 of FIG. 5) are electrically coupled with the membrane 210 in a vicinity of a sample 260 and used to restrict the portion of the membrane 210 through which an electrical current is directed. In this way, operations for removing membrane material can be omitted in at least some iterations of the example processes of the present disclosure (e.g., example process 600 of FIG. 6). In FIG. 7B, the techniques described in reference to FIGs. 2C-2H can be adapted to define a peripheral region 645 in the vicinity of a sample, where the pattern defined as part of example process 600 (e.g., in operation 610 and operation 615 of FIG. 6) can include multiple apertures 640 that together at least partially isolate the sample and the peripheral region 645 from one or more of the conductive portions of the heating assembly support structure (e.g., support 215 of FIG. 2A, portion(s) 220 of FIG. 2A, etc.). In FIG. 7C, multiple conductive paths are defined using multiple probes 555 that are electrically coupled with the membrane 210. Multiple apertures 640 are used to define the peripheral region of the membrane. Advantageously, the multi-path configuration illustrated permits nuanced dynamics and a level of spatially localized heating to be applied to the sample, for example, where the membrane 210 and/or the sample exhibit anisotropic electrical conductivity/resistivity or other thermal and/or electrical properties. For example, the four probe configuration allows for resistance measurement of the area defined by the apertures 640, from which a temperature of the membrane can be estimated.

### EXAMPLE 1: LOCALIZED HEATING OF VARIOUS MATERIAL SAMPLES

The following paragraphs describe experimental data generated using systems of the present disclosure. The following images represent detector data revealing phase transition from solid to liquid of various metal particles disposed on a membrane through which an electrical current is directed to induce heating. The data indicate that, at least in the vicinity of the samples, the membrane heated to a point where the metal melted and became liquid or amorphous. The experimental conditions include a membrane of multiwall carbon nanotubes and a direct current at a power from about 3 Watts to about 5 W for non-local heating to about 1350 K (e.g., as described in FIGs. 2A-2H) and from of about 0.2 W to about 0.6 W for localized or partially-localized heating (e.g., as described in FIGs. 6-7C) to comparable temperatures. The experimental duration was about 30 seconds, and the thermal rise time of the membranes was significantly shorter, heating from about 300 K to about 1300 K in about 0.1 seconds.

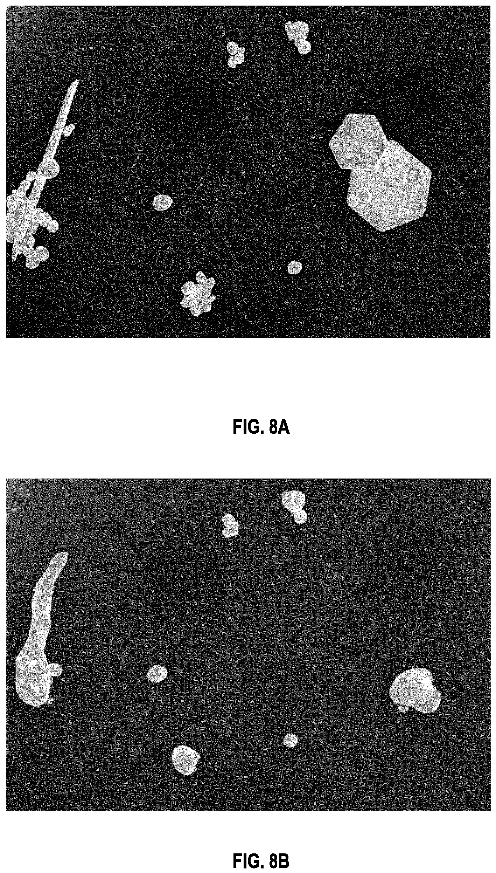

**FIGs. 8A-8B** are electron micrograph images demonstrating heating of an example material sample, in accordance with some embodiments of the present disclosure. The sample included gold, characterized by a melting temperature of 1337 K under the conditions in an SEM. In this way, the membrane was able to reversibly heat the sample to a temperature at or above 1337 K, using electrical heating induced by directing a current through the membrane.

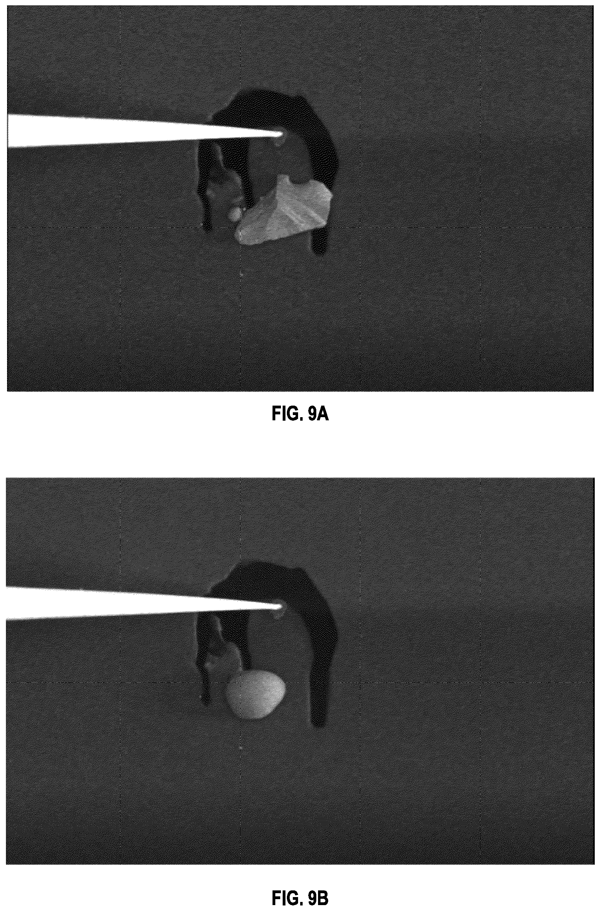

**FIGs. 9A-9B** are electron micrograph images demonstrating local heating of an example material sample, in accordance with some embodiments of the present disclosure. The sample included silicon, characterized by a melting temperature of 1687 K under the conditions in an SEM. In this way, the membrane was able to reversibly heat the sample to a temperature at or above 1687 K, using electrical heating induced by directing a current through the membrane. The experiment from which the data in FIGs. 9A-9B were collected included performing at least some of the operations of example process 600 of FIG. 6, whereby a peripheral region of the membrane was defined in a vicinity of the sample and a probe tip was used to direct the heating current through the membrane. The phase transition of the silicon is revealed in the formation of a smooth surface and the collection of sample material into a spheroid shape, in line with a physical tendency to minimize surface energy in liquids.

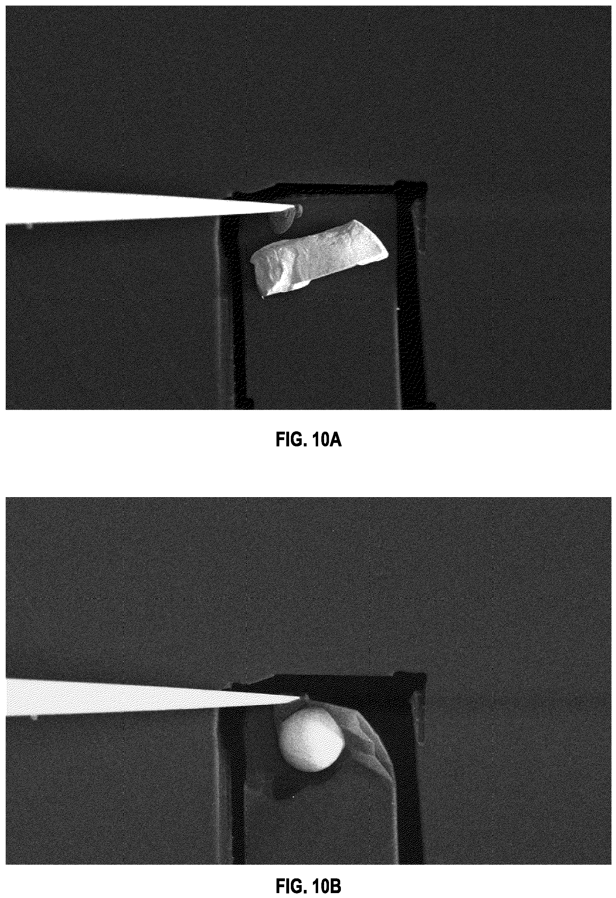

**FIGs. 10A-10B** are electron micrograph images demonstrating local heating of an example material sample, in accordance with some embodiments of the present disclosure. The sample included platinum, characterized by a melting temperature of 2041 K under the conditions in an SEM. In this way, the membrane was able to reversibly heat the sample to a temperature at or above 2041 K, using electrical heating induced by directing a current through the membrane. The experiment from which the data in FIGs. 9A-9B were collected included performing at least some of the operations of example process 600 of FIG. 6, whereby a peripheral region of the membrane was defined in a vicinity of the sample and a probe tip was used to direct the heating current through the membrane. The deformation of the membrane observed in FIG. 10B is attributed to surface tension effects of the platinum forming a droplet (e.g., minimizing surface energy) while remaining wetted to the surface of the membrane.

### EXAMPLE 2: GENERATING PRECURSOR VAPOR FOR EBID/IBID PROCEDURES

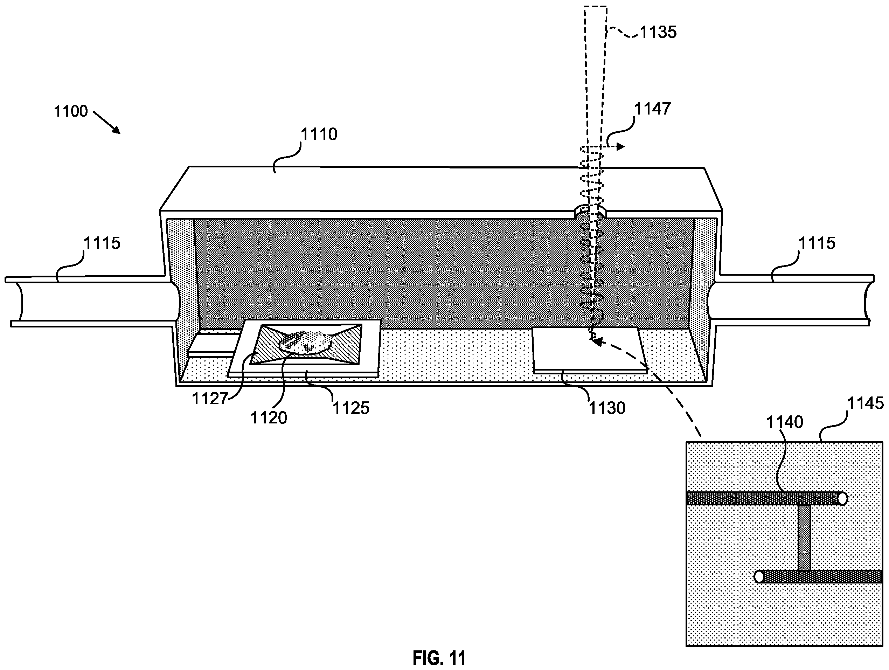

**FIG. 11** is a schematic diagram illustrating an example system 1100 for charged particle beam induced deposition, in accordance with some embodiments of the present disclosure. The example system 1100 includes an isolation chamber 1110 for containing a vapor generated by heating a sample material 1120 using a heating assembly 1125 of the present disclosure. A carrier gas can be introduced via a conduit 1115 fluidically coupled with the chamber. The carrier gas can entrain the vaporized sample and can conduct the vapor to the vicinity of a deposition substrate 1130. A beam of charged particles 1135 (e.g., a beam of ions, a beam of electrons, etc.) and/or a beam of photons (e.g., a laser) can be directed toward the deposition substrate 1130 to induce a deposition process in which the vapor acts as a deposition precursor. Such techniques can be used to deposit patterns of material 1140. The deposited material 1140 can be chemically identical, similar, or different from the sample material from which the precursor was generated. For example, multiple precursors can be generated using one or more heating assemblies of the present disclosure, such that the beam-induced deposition process includes a chemical reaction of the precursors that yields a solid deposition material. In some cases, the deposition process uses the energy of the beam (e.g., when an inert ion such as argon or xenon is used) to elicit the deposition process. Advantageously, the heating assemblies of the present disclosure provide improved performance, such as heating time, energy efficiency, and geometric size constraints, permitting the miniaturization and integration of the system 1100 into charged particle beam systems of the present disclosure. Further, the composition of the deposited material 1140 can be modulated by adjusting the operation of the heating assembly 1125 (e.g., by adjusting the current directed through the membrane(s) 1127). In some embodiments, detector data 1145 can be generated from the interaction of the beam of charged particles 1135 with the deposition substrate 1130 (e.g., secondary electrons 1147), with which the deposition process can be controlled.

The system 1100 enables chemical vapor deposition using precursor materials that cannot be delivered to the vicinity of a deposition substrate 1130 using standard devices for gas delivery (e.g., gas injection needle systems), due at least in part to the tendency for such materials to condense in delivery lines an on other surfaces, which are at relatively low temperature (typically at room temperature or below 200 deg C). Precursor materials such as perovskites, tellurium, selenide, sulfur and others can be placed in proximity to the deposition substrate 1130 and heated to induce vaporization and/or sublimation. To that end, the heater 1125 of precursor material 1120 can be maintained at a higher temperature (typically in the range of about 400 deg C to about 1500 deg C) than that of the deposition substrate 1130. The deposition substrate 1130 can be heated to temperatures between about 100 deg C and about 1200 deg C.

Thermal radiation generated by the heating assembly 1125, which can be the hottest part of the system 1100, can impair the performance of SEM detectors (155, 160, 175) that can be sensitive to IR radiation and light emitted by the heated parts. The heating assembly 1125 can be shaped to minimize the power needed for the evaporation of precursor material. For example, it is possible to localize heating to the vicinity of the precursor material 1120 using the shaping techniques described in Figs 6 and 7. Heater shaping is possible before (e.g., where precise sample placement is performed) and/or after the placement of the precursor material 1120 on the heater 1125 before the in situ vapor deposition experiment, when at least a portion of the isolation chamber 1110 (e.g., a cover portion) can be removed to allow access of FIB or manipulator needle used for shaping to the heater 1125. In some cases, some of the thermal radiation generated by the heating assembly 1125 can be absorbed by the deposition substrate 1130, affecting the local temperature and heating control stability. Advantageously, the heating assemblies of the present disclosure, characterized by about one order of magnitude lower thermal radiance (e.g., dissipating about 4 W as opposed to about 40 W for typical bulk heating stages) influence the temperature of the deposition substrate 1130 to a significantly lesser extent, improving accuracy, stability, and precision of thermal control of the deposition substrate 1130.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on charged particle beam systems, and electron microscopy systems in particular, these are meant as non-limiting, illustrative embodiments. Embodiments of the present disclosure are not limited to such embodiments, but rather are intended to address analytical instruments systems for which a wide array of material samples can be analyzed to determine chemical, biological, physical, structural, or other properties, among other aspects, for which temperature dependence is of interest.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A heating assembly, comprising:
a membrane, comprising carbon nanotube material;
a support, mechanically coupled with the membrane, the support being configured to integrate with a charged particle beam system; and
a heating circuit, electrically coupled with the membrane and configured to direct an electrical current through the membrane.

2. The assembly of claim 1, wherein the membrane defines a shape including a taper, the taper being defined in a plane in cartesian coordinate space.

3. The assembly of claim 2, wherein the shape includes a double taper in the plane, such that a central region of the membrane is narrower than a peripheral region of the membrane.

4. The assembly of any one of the preceding claims, wherein the support includes an electrically conductive portion, in electrical contact with the membrane and electrically coupled with the heating circuit, the heating circuit being configured to direct the electrical current through the membrane via the electrically conductive portion.

5. The assembly of any preceding claim, wherein the heating circuit comprises a probe, the probe being configured to electrically couple with the membrane or the support.

6. The assembly of claim 5, wherein the probe is a first probe, and wherein the heating circuit further comprises a second probe, reversibly coupled with the membrane, such that the electrical current is directed from the first probe to the second probe, via the membrane.

7. The assembly of any one of the preceding claims, wherein the membrane is at least partially freestanding across an aperture defined in the support, and/or comprises multiple layers of carbon nanotube material.

8. The assembly of any one of the preceding claims, wherein the carbon nanotube material includes multiwall carbon nanotube felt.

9. A charged particle beam system, comprising:
a charged particle beam source;
a sample chamber, coupled with the charged particle beam source; and
a heating assembly in accordance with any one of the preceding claims, the heating chamber being disposed in the sample chamber, wherein the support is reversibly coupled with a sample stage of the charged particle beam system and configured for a sample to be disposed thereon and irradiated by a charged particle beam generated by the charged particle beam source.

10. The system of claim 9 when dependent upon claim 5, wherein the probe is electrically coupled with a conductive portion of the support.

11. The system of claim 9 or claim 10, further comprising an isolation chamber, comprising a fluid handling coupling and a deposition substrate, wherein the heating assembly is disposed in the isolation chamber between the fluid handling coupling and the deposition substrate.

12. A method for heating a sample, the method comprising:
directing an electrical current through a membrane of a heating assembly, the heating assembly comprising:
the membrane, comprising carbon nanotube material, the sample being disposed on the membrane;
a support, mechanically coupled with the membrane, the support being reversibly coupled with a sample stage of a charged particle beam system; and
a heating circuit, electrically coupled with the membrane and the charged particle beam system and configured to direct an electrical current through the membrane.

13. The method of claim 12, wherein directing the electrical current through the membrane comprises applying a power of about 30 W or less through the membrane.

14. The method of claim 12 or claim 13, wherein the membrane has a sample disposed thereon, the method further comprising:
removing material from the membrane in a region of the membrane peripheral to the sample; and
contacting the membrane with a probe, electrically coupled with the heating circuit, within the region peripheral to the sample.

15. The method of claim 14, wherein removing the material comprises irradiating the membrane using a beam of charged particles.
